(19) **Europäisches Patentamt / European Patent Office / Office européen des brevets**

(11) **EP 2 617 051 B1**

(12) **FASCICULE DE BREVET EUROPEEN**

(45) Date de publication et mention
de la délivrance du brevet:
**31.07.2019 Bulletin 2019/31**

(51) Int Cl.:
*H01J 43/24* (2006.01)      *H01J 9/12* (2006.01)
*H01J 1/32* (2006.01)       *B82Y 30/00* (2011.01)
*C01B 32/25* (2017.01)

(21) Numéro de dépôt: **11752573.3**

(22) Date de dépôt: **09.09.2011**

(86) Numéro de dépôt international:
**PCT/EP2011/065674**

(87) Numéro de publication internationale:
**WO 2012/034948 (22.03.2012 Gazette 2012/12)**

(54) **DISPOSITIF MULTIPLICATEUR D'ÉLECTRONS A COUCHE DE NANODIAMANT**

ELEKTRONENMULTIPLIKATOR MIT EINER NANODIAMANTSCHICHT

ELECTRON MULTIPLIER TUBE WITH A NANODIAMOND LAYER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.09.2010 FR 1057276**

(43) Date de publication de la demande:
**24.07.2013 Bulletin 2013/30**

(73) Titulaire: **Photonis France
19100 Brive La Gaillarde (FR)**

(72) Inventeurs:
 • **NÜTZEL, Gert
 Delft, 2611 RV (NL)**
 • **LAVOUTE, Pascal
 F-19100 Brive-la-gaillarde (FR)**
 • **JACKMAN, Richard B.
 Abbots Langley Hertfordshire WD5 0AZ (GB)**

(74) Mandataire: **Ilgart, Jean-Christophe et al
BREVALEX
95, rue d'Amsterdam
75378 Paris Cedex 8 (FR)**

(56) Documents cités:
**EP-A2- 0 908 917      WO-A1-89/09484
US-A- 5 680 008        US-A1- 2008 073 127
US-A1- 2009 212 680    US-A1- 2009 315 443**

• **LAPINGTON JON ET AL: "DETECTORS: Diamond dynodes create new breed of photon detectors", Laser Focus World, 25 août 2008 (2008-08-25), XP007918721, Extrait de l'Internet: URL:http://www.laserfocusworld.com/display _article/336816/12/none/none/WebX/detector s:-diamond-dynodes-create-new-breed-of-pho ton-detector [extrait le 2011-05-23]**
• **FOX N A ET AL: "Properties of electron field emitters prepared by selected area deposition of CVD diamond carbon films", DIAMOND AND RELATED MATERIALS, ELSEVIER SCIENCE PUBLISHERS, AMSTERDAM, NL, vol. 9, no. 3-6, 1 avril 2000 (2000-04-01) , pages 1263-1269, XP004199959, ISSN: 0925-9635, DOI: DOI:10.1016/S0925-9635(99)00262-9**
• **WILLIAMS ET AL: "Enhanced diamond nucleation on monodispersed nanocrystalline diamond", CHEMICAL PHYSICS LETTERS, NORTH-HOLLAND, AMSTERDAM, NL, vol. 445, no. 4-6, 6 septembre 2007 (2007-09-06), pages 255-258, XP022233609, ISSN: 0009-2614, DOI: DOI:10.1016/J.CPLETT.2007.07.091 cité dans la demande**
• **LI C C ET AL: "Preparation of clear colloidal solutions of detonation nanodiamond in organic solvents", COLLOIDS AND SURFACES. A, PHYSICACHEMICAL AND ENGINEERING ASPECTS, ELSEVIER, AMSTERDAM, NL, vol. 353, no. 1, 5 janvier 2010 (2010-01-05), pages 52-56, XP026794832, ISSN: 0927-7757 [extrait le 2009-10-24]**

**(Cont. page suivante)**

- Anonymous: "Microchannel Plates", , 11 March 2009 (2009-03-11), XP055455728, Retrieved from the Internet: URL:https://web.archive.org/web/2009031100 3029/http://www.dmphotonics.com/MCP_MCPI ma geIntensifiers/microchannel_plates.htm [retrieved on 2018-03-01]

**Description**

**DOMAINE TECHNIQUE**

La présente invention se rapporte au domaine général des dispositifs multiplicateurs d'électrons en réflexion présents dans les tubes de détection de rayonnement électromagnétique ou de flux ionique.

Le dispositif multiplicateur d'électrons selon l'invention est dit en réflexion dans la mesure où il comprend une même face par laquelle il reçoit un flux d'électrons dits incidents et émet en réponse un flux d'électrons dits secondaires. Il se distingue en cela des multiplicateurs d'électrons en transmission pour lesquelles la face de réception et la face d'émission sont distinctes l'une de l'autre.

A titre illustratif, un tel dispositif multiplicateur d'électrons en réflexion peut être une galette de microcanaux ou un ensemble de dynodes, disposé dans un tube photomultiplicateur, un tube intensificateur d'image voire un tube de détection ionique.

**ÉTAT DE LA TECHNIQUE ANTÉRIEURE**

Les tubes de détection de rayonnement électromagnétique ou de flux ionique, tels que les tubes photomultiplicateurs, les tubes intensificateurs d'image et les tubes de détection ionique, comportent habituellement un dispositif d'entrée pour recevoir le rayonnement électronique ou le flux ionique et émettre en réponse un flux d'électrons dits primaires, un dispositif multiplicateur d'électrons pour recevoir ledit flux d'électrons primaires et émettre en réponse un flux d'électrons dits secondaires, puis un dispositif de sortie pour recevoir ledit flux d'électrons secondaires et émettre en réponse un signal de sortie.

Le multiplicateur d'électrons comprend au moins une structure active destinée à recevoir un flux d'électrons incidents et à émettre en réponse un flux d'électrons dits secondaires.

Il peut être du type multiplicateur d'électrons en réflexion, la structure active présentant alors une même face d'émission et de réception d'électrons. Il peut être formé, par exemple, d'une galette de microcanaux (GMC) ou d'un ensemble de dynodes.

La GMC est un multiplicateur d'électrons à gain élevé qui se présente habituellement sous la forme d'une fine plaque, comportant un réseau de micro-canaux qui la traversent d'une face amont orientée vers le dispositif d'entrée vers une face opposée aval orientée vers le dispositif de sortie.

Deux électrodes sont disposées l'une sur la face amont de la GMC, l'autre sur la face aval. La GMC est ainsi soumise à une différence de potentiel entre ses deux faces de manière à générer un champ électrique.

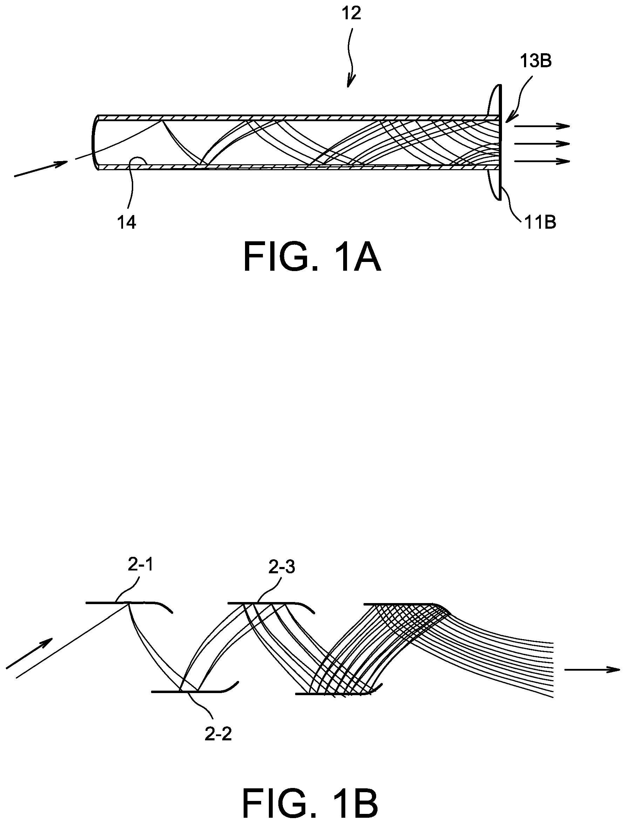

Comme le montre la figure 1A qui est une vue schématique et partielle d'un microcanal 12 d'une GMC, lorsqu'un électron primaire entre dans un microcanal 12 et heurte la paroi intérieure 14 de celui-ci, des électrons secondaires sont générés, qui, en venant à leur tour heurter la paroi 14, génèrent d'autres électrons secondaires. Les électrons sont dirigés et accélérés par le champ électrique vers l'orifice de sortie 13B du microcanal 12 situé au niveau de la face aval 11B de la GMC.

Ainsi, la structure active de la GMC comprend essentiellement le substrat formant ladite plaque, celui-ci étant réalisé en verre au plomb. Un traitement de réduction du plomb est effectué pour optimiser le taux d'émission secondaire et rendre semi-conductrice la paroi intérieure de chaque microcanal. La paroi intérieure de chaque microcanal est ensuite électriquement connectée à une source externe de tension, ce qui permet de fournir à chaque microcanal les électrons destinés à être émis.

La GMC présente un gain global G qui dépend du gain élémentaire $\delta_i$, ou taux local d'émission secondaire, à chaque étape i de multiplication, et du nombre n d'étape de multiplication dans chaque microcanal, selon la relation suivante :

$$G = \prod_i^n \delta_i \qquad (1)$$

De plus, la GMC présente un rapport signal sur bruit qui dépend du facteur de bruit F en $F^{-1/2}$. Or, le facteur de bruit F dépend également du gain élémentaire $\delta_i$ et du nombre n d'étape de multiplication dans chaque microcanal, comme l'exprime la relation suivante :

$$F = 1 + \frac{1}{\delta_1} + \frac{1}{\delta_1 \delta_2} + \frac{1}{\delta_1 \delta_2 \delta_3} ... + \frac{1}{\delta_1 \delta_2 ... \delta_n} \qquad (2)$$

où $\delta_1 \sim 3\text{-}5$ et $\delta_{i>1} \sim 2$.

Ainsi, augmenter du gain global G de la GMC peut consister à augmenter la longueur de chaque microcanal pour augmenter le nombre d'étapes de multiplication. Cependant, comme le montre la relation (2), cela entraîne *de facto* une augmentation du facteur de bruit F, et donc une diminution du rapport signal sur bruit. Ainsi, augmenter le gain global de la GMC s'accompagne d'une dégradation de la qualité de son signal.

Une autre possibilité pour augmenter le gain global de la GMC sans dégrader le rapport signal sur bruit peut consister à utiliser la technique connue de dépôt chimique en phase vapeur (CVD en anglais, pour *chemical vapor deposition*) pour déposer un film mince d'un matériau à haut taux d'émission secondaire sur la paroi intérieure des microcanaux de la GMC. Cependant, cela nécessiterait de soumettre le substrat de la GMC à une température de plus de 800°C sur des temps longs, ce qui est inenvisageable dans la mesure où le substrat en verre au plomb de la GMC ne peut être soumis à plus de 430°C sans subir une dégradation de sa structure et donc de ses performances.

Alternativement à la GMC, un dispositif multiplicateur d'électrons en réflexion peut être formé d'un ensemble de dynodes 2-1, 2-2, 2-3... dont la configuration peut être, de manière connue, du type *venetian blind, box, linear focusing, circular cage, mesh,* ou *foil.* Une représentation de ces différentes catégories de dynodes peut être trouvée dans l'ouvrage de Wernick & Aarsvold, 2004, Emission tomography : the fundamentals of PET and SPECT, Academic Press Inc.

Le dispositif multiplicateur présente un gain global G qui s'écrit selon la même relation que pour une GMC, où $\delta_i$ est alors le gain élémentaire de l'étape i de multiplication, ici la dynode i, et du nombre n de dynodes.

L'ensemble de dynodes présente également un temps de montée (*Rise Time,* en anglais) qui dépend directement du gain élémentaire $\delta_i$ de chaque dynode et du nombre n de dynodes, comme l'exprime la relation suivante :

$$ RT \propto \left( \sum_{i}^{n} \sigma_i \right)^{1/2} \qquad\qquad (3) $$

où $\sigma_i$ est l'étalement en temps du signal au niveau de la dynode i. Le temps de montée RT est classiquement défini comme l'écart de temps entre 10% et 90% de la valeur maximale d'une impulsion de courant à l'anode (dispositif de sortie) du système de détection, en réponse à une impulsion de lumière modélisée par une fonction delta.

Ainsi, augmenter du gain global G de l'ensemble de dynodes peut consister à augmenter le nombre n de dynodes, mais entraîne *de facto* une augmentation du temps de montée RT. Ainsi, augmenter le gain global de l'ensemble de dynodes s'accompagne d'une dégradation de la résolution temporelle du multiplicateur.

Le document US-A-2009/0212680 concerne une galette de microcanaux dont la surface interne peut être revêtue d'une couche de diamant.

## EXPOSÉ DE L'INVENTION

L'invention a principalement pour but de présenter un dispositif multiplicateur d'électrons en réflexion présentant un gain global élevé pour un rapport signal sur bruit ou un temps de montée préservé ou amélioré, tout en maintenant une résolution spatiale élevée.

L'invention est définie par un dispositif selon la revendication 1 et un procédé de réalisation selon la revendication 12. Des modes de réalisation avantageux sont précisés dans les revendications dépendantes.

D'autres avantages et caractéristiques de l'invention apparaîtront dans la description détaillée non limitative ci-dessous.

## BRÈVE DESCRIPTION DES DESSINS

On décrira à présent, à titre d'exemples non limitatifs, des modes de réalisation de l'invention, en se référant aux dessins annexés, dans lesquels :

La figure 1A, déjà décrite, est une vue schématique en coupe longitudinale d'un microcanal d'une galette de micro-canaux selon l'art antérieur ;

La figure 1B, déjà décrite, est une vue schématique en coupe longitudinale d'un ensemble de dynodes de type *linear focusing* selon l'art antérieur ;

La figure 2 est une vue schématique en coupe longitudinale d'un premier dispositif multiplicateur d'électrons comportant une galette de microcanaux permettant de comprendre l'invention ;

La figure 3 est une vue schématique en coupe longitudinale d'un second dispositif multiplicateur d'électrons comportant une galette de microcanaux permettant de comprendre l'invention ;

La figure 4 est une vue schématique en coupe longitudinale d'un dispositif multiplicateur d'électrons comportant une galette de microcanaux selon une variante du dispositif représenté sur la figure 3 ;
La figure 5 est une vue schématique en coupe longitudinale d'un dispositif multiplicateur d'électrons comportant un ensemble de dynodes, utile à la compréhension de l'invention.

**EXPOSÉ DÉTAILLÉ D'UN MODE DE RÉALISATION PRÉFÉRÉ**

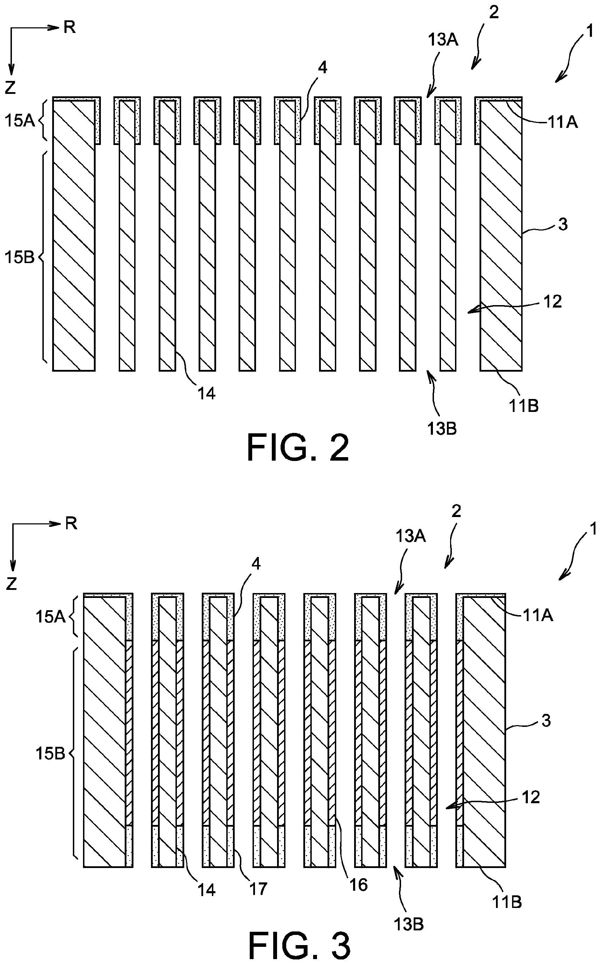

La figure 2 illustre partiellement et de manière schématique un premier dispositif multiplicateur 1 d'électrons utile à la compréhension de l'invention, comportant essentiellement une galette de microcanaux 2 (GMC).

Ce multiplicateur 1 peut être utilisé dans un système de détection de rayonnement électromagnétique ou de flux ionique. On considère ici qu'il est disposé dans un tube intensificateur d'image, mais il peut également être utilisé dans un tube photomultiplicateur ou un tube de détection d'un flux ionique.

Il est à noter que les échelles ne sont pas respectées, pour privilégier la clarté du dessin.

Dans toute la description qui va suivre, on utilise un repère orthonormé (R,Z) en coordonnées cylindriques où R est la direction radiale du tube et Z est la direction axiale du tube qui est également sensiblement assimilable au sens général de propagation des électrons.

Par ailleurs, les termes « amont » et « aval » utilisés par la suite sont ici à comprendre en termes d'orientation suivant la direction Z du repère (R,Z).

Le tube intensificateur d'image peut présenter une forme sensiblement cylindrique ou tubulaire suivant l'axe Z. Cependant, le tube peut également présenter une forme de section carrée, rectangulaire, hexagonale, ou toute autre forme.

Le tube comprend trois éléments principaux disposés suivant la direction Z, à savoir un dispositif d'entrée (non représenté), le multiplicateur 1 d'électrons et un dispositif de sortie (non représenté). Le tube comprend également un corps de tube (non représenté) dont la fonction est d'assurer la tenue mécanique des trois éléments cités précédemment, de définir une chambre étanche, en coopération avec les dispositifs d'entrée et de sortie, et de permettre l'alimentation en tension des différentes électrodes prévues pour imposer différents champs électriques. Les trois éléments sont sensiblement alignés suivant l'axe du tube Z.

Dans le cas d'un tube intensificateur d'image, le dispositif d'entrée comprend une photocathode qui reçoit les photons incidents provenant de l'environnement extérieur pour les convertir en photoélectrons suivant un motif correspondant à l'image de l'environnement observé. Le multiplicateur 1 d'électrons amplifie les photoélectrons qui sont ensuite transformés par le dispositif de sortie en un signal lumineux intensifié au moyen d'un écran phosphore, d'un capteur CMOS ou d'un capteur CCD, voire d'une simple anode quand il ne s'agit pas d'application imagerie.

Selon l'invention, le multiplicateur 1 d'électrons comporte une structure active 2 destinée à recevoir un flux d'électrons incidents et à émettre en réponse un flux d'électrons dits secondaires. Ladite structure active 2 comporte un substrat 3 sur lequel est disposée une couche mince de nanodiamant 4 formée de particules de diamant dont la taille moyenne est inférieure ou égale à 100nm, et préférentiellement inférieure ou égale à 10nm.

Dans le cadre de l'invention, la structure active 2 est une galette de microcanaux (GMC).

La GMC est formée d'un substrat 3 comportant un réseau de microcanaux 12 qui traversent le substrat 3 à partir de sa face amont 11A orientée vers le dispositif d'entrée jusqu'à sa face aval 11B orientée vers le dispositif de sortie.

Ainsi, chaque microcanal 12 présente un orifice d'entrée 13A pour le flux de photoélectrons, situé au niveau de la face amont 11A de la GMC 2, et un orifice de sortie 13B pour le flux d'électrons secondaires, situé au niveau de la face aval 11B.

La couche de nanodiamant 4 s'étend de manière sensiblement continue sur la surface intérieure 14 de chaque microcanal 12, à partir de l'orifice d'entrée 13A et en direction de l'orifice de sortie 13B.

La couche de nanodiamant 4 est disposée dans le microcanal 12 de manière à ce qu'elle assure au moins la première étape de multiplication des électrons.

La couche de nanodiamant 4 est ici directement au contact de la surface intérieure 14 de chaque microcanal 12.

En aval de la couche de nanodiamant 4 suivant la direction Z, la surface intérieure 14 du microcanal 12 n'est plus recouverte par la couche de nanodiamant.

Chaque microcanal 12 présente donc une première zone amont 15A dans laquelle la surface intérieure 14 du microcanal 12 est recouverte par la couche de nanodiamant 4, suivie, suivant la direction Z, d'une seconde zone aval 15B ne comportant pas de couche de nanodiamant.

Il est par ailleurs à noter que la couche de nanodiamant 4 est traitée à l'hydrogène, au césium ou à l'oxyde de césium pour en diminuer l'affinité électronique. Ainsi, les électrons générés par émission secondaire peuvent s'en extraire naturellement.

Le substrat 3 est avantageusement réalisé en verre au plomb dont la réduction du plomb a été effectuée. Ainsi, le substrat 3 présente, au niveau de la surface intérieure 14 des microcanaux 12, un taux local d'émission secondaire optimisé, ainsi qu'une conductivité électrique suffisante pour permettre l'approvisionnement en électrons destinés à être émis.

Par ailleurs, la surface intérieure 14 de chaque microcanal 12 est électriquement connectée à une même source de tension (non représentée) formant réservoir d'électrons pour la couche de nanodiamant 4 d'une part, et pour la seconde zone aval 15B de la surface intérieure 14 des microcanaux 12 d'autre part.

Ainsi, la surface intérieure 14 des microcanaux 12 de la GMC 2 en verre au plomb assure, au niveau de la première zone amont 15A, essentiellement une fonction électrique de fourniture d'électrons à la couche de nanodiamant 4, l'émission des électrons secondaires étant assurée, dans cette zone, par la couche de nanodiamant 4.

De plus, au niveau de la seconde zone aval 15B, la surface intérieure 14 assure, en plus de la fourniture des électrons destinés à être émis, la fonction supplémentaire d'émission des électrons secondaires.

Enfin, le multiplicateur 1 comporte deux électrodes de polarisation (non représentées) disposées l'une sur la face amont 11A de la GMC 2, l'autre sur la face aval 11B. Ces deux électrodes, électriquement connectées à une source de tension (non représentée), permettent de générer à l'intérieur de la GMC un champ électrique destiné à orienter et à accélérer les électrons secondaires en direction de l'orifice de sortie 13B.

Il est à noter que la source de tension formant réservoir d'électrons peut également être celle assurant la génération du champ électrique, par le biais des deux électrodes de polarisation. L'électrode de polarisation disposée sur la face aval de la GMC peut alors assurer le raccord électrique de la surface intérieure 14 de chaque microcanal 12 à ladite source de tension.

Comme décrit précédemment, la GMC 2 selon le premier mode de réalisation est réalisée à partir, principalement d'oxyde de silicium ($SiO_2$) et d'oxyde de plomb (PbO).

Les microcanaux 12 présentent un diamètre moyen de l'ordre de, par exemple, $2\mu m$ à $100\mu m$ et un rapport longueur sur diamètre de l'ordre de, par exemple, 40 à 100.

La couche de nanodiamant 4 est formée de particules de diamant de taille moyenne inférieure ou égale à 100nm, de préférence comprise entre 1nm et 50nm, de préférence comprise entre 5nm et 10nm, de préférence de l'ordre de 6nm.

La couche de nanodiamant 4 est dite particulaire, ou granulaire, ou discrète, et n'est donc pas physiquement continue au sens des milieux continus.

L'épaisseur moyenne de la couche de nanodiamant 4 est de l'ordre de grandeur de la taille moyenne des particules de diamant, de sorte que la couche de nanodiamant 4 est sensiblement une monocouche. Son épaisseur moyenne est sensiblement comprise entre 1nm et 100nm, de préférence de l'ordre de 6nm.

Les électrodes de polarisation peuvent être réalisées à partir de nickel-chrome, et s'étendent sur la face amont et la face aval de la GMC. D'autres matériaux tels que ITO peuvent également être utilisés.

La réalisation de la couche de nanodiamant sur la GMC est maintenant décrite en détail, en référence aux articles de Williams et al., dont l'un est intitulé Enhanced diamond nucleation on monodispersed nanocrystalline diamond, 2007, Chem. Phys. Lett., 445, 255-258, et l'autre est intitulé Growth, electronic properties and applications of nanodiamond, 2008, Diam. Relat. Mater., 17, 1080-1088.

On réalise tout d'abord de la poudre de diamant formée de particules de diamant dont la taille moyenne est inférieure ou égale à 100nm, de préférence comprise entre 1nm et 10nm, et avantageusement de l'ordre de 6nm.

Pour cela, la technique connue de détonation est utilisée. Cependant, lors du cycle de refroidissement de l'onde de choc de détonation, des agrégats de particules de diamant dont la taille moyenne est sensiblement supérieure à 100nm sont formés qui rendent hétérogène la distribution en taille moyenne des particules.

Pour rendre homogène la distribution en taille de la poudre obtenue par détonation, celle-ci est broyée (*milling,* en anglais) à l'aide de grains de zircone (*zirconia beads,* en anglais). Le détail de cette procédure est notamment décrit dans l'article de Williams 2007 précédemment cité.

Le mélange issu de cette étape de broyage est ensuite filtré et nettoyé par des traitements agressifs d'acides, permettant ainsi d'obtenir une suspension stable de particules de nanodiamant dont la distribution en taille est homogène. La taille moyenne des particules de nanodiamant est de l'ordre de 6nm, avec une distribution en taille comprise entre 5nm et 10nm environ.

Selon un mode de réalisation de l'invention, on plonge ensuite la GMC à partir de la face amont dans une solution colloïdale d'eau ou d'éthanol contenant de ladite poudre de nanodiamant, dans un bain à ultrasons, pendant une durée prédéterminée, par exemple 30mn.

Les particules de nanodiamant se déposent alors sur la surface intérieure des microcanaux, formant ainsi ladite couche de nanodiamant.

La durée du bain à ultrasons permet notamment de contrôler la longueur d'étalement de la couche de nanodiamant le long des microcanaux, à partir de l'orifice d'entrée respectif.

La GMC ainsi obtenue est enfin rincée à l'eau désionisée pure et séchée (*blow-dried*) à l'azote. Un multiplicateur d'électrons comportant une GMC dont la structure active comprend une couche de nanodiamant est alors obtenu.

Ainsi, lorsqu'un flux de photoélectrons entre dans les microcanaux 12, ils heurtent la couche de nanodiamant 4 qui émet en réponse un flux d'électrons secondaires avec un gain élémentaire $\delta_1$. Les électrons secondaires émis peuvent ensuite heurter plusieurs fois la couche de nanodiamant 4 avant de venir heurter la surface intérieure 14 des microcanaux 12 située dans la seconde zone aval 15B, ou heurter directement la surface intérieure 14 des microcanaux 12 située dans la seconde zone aval 15B. Après un nombre n d'étapes de multiplication, dont au moins la première est assurée par la couche de nanodiamant 4, un flux d'électrons secondaires sort de chaque microcanal 12 par l'orifice de sortie 13B, en direction de l'écran phosphore du tube intensificateur d'image.

Le multiplicateur d'électrons représenté en figure 2 présente ainsi plusieurs avantages.

En effet, dans la mesure où le diamant est connu pour présenter un haut rendement d'émission secondaire, supérieur notamment au verre à plomb, le multiplicateur d'électrons présente un gain global particulièrement élevé dans la mesure où au moins la première étape de multiplication est réalisée par la couche de nanodiamant. Le gain élémentaire $\delta_1$ au niveau de la première étape de multiplication est, en effet, de 5 à plus de 60, par exemple de l'ordre de 5, 10, 20, 30, 40, 50, 60, ou plus, alors qu'il est de l'ordre de 3 à 5 pour le verre au plomb. De plus, selon la relation (2), le facteur de bruit est diminué, ce qui augmente également le rapport signal sur bruit.

Ainsi, sans qu'il soit nécessaire d'augmenter la longueur des microcanaux, le multiplicateur d'électrons selon la figure 2 présente un gain global élevé et améliore le rapport signal sur bruit par rapport aux GMC au verre au plomb selon l'art antérieur.

Selon un mode de réalisation de l'invention, dans le cas du tube intensificateur d'image, et dans le but de ne pas dégrader la résolution spatiale, la couche de nanodiamant s'étend avantageusement le long du microcanal, mais s'arrête à une distance de l'ordre de une à dix fois le diamètre moyen des microcanaux à partir de l'orifice de sortie. Dans ce cas, une couche 17 de collection d'électrons (représentée sur la figure 3) réalisée en un matériau conducteur à taux sensiblement nul d'émission secondaire est déposée sur la surface intérieure du microcanal sur ladite distance de l'ordre de une à dix fois le diamètre moyen des microcanaux à partir de l'orifice de sortie. Ainsi, les électrons incidents heurtant cette couche de collection, dans cette zone dite de collection, sont absorbés par ladite couche, sans que soient émis des électrons secondaires. La résolution spatiale du multiplicateur est ainsi préservée.

La figure 3 illustre un second dispositif multiplicateur d'électrons.

Les références numériques identiques à celles de la figure 2 précédemment décrite désignent des éléments identiques ou similaires.

Ce dispositif diffère du précédent essentiellement en ce que la surface intérieure 14 des microcanaux 12 dans la seconde zone amont 15B est recouverte d'une couche mince 16 d'$Al_2O_3$, matériau à taux élevé d'émission secondaire.

La couche mince 16 d'$Al_2O_3$ peut présenter une épaisseur de l'ordre de 5nm et s'étendre le long du microcanal 12, mais s'arrête ici à une distance de l'ordre de une à dix fois le diamètre moyen des microcanaux à partir de l'orifice de sortie 13B. Comme mentionné précédemment, une couche 17 de collection d'électrons réalisée en un matériau conducteur à taux sensiblement nul d'émission secondaire est déposée sur la surface intérieure 14 du microcanal 12 sur ladite distance de l'ordre de une à dix fois le diamètre moyen des microcanaux à partir de l'orifice de sortie. La résolution spatiale du multiplicateur, dans le cas notamment d'un tube intensificateur d'image, est ainsi préservée.

Il est alors à noter que la surface intérieure 14 du microcanal 12 assure alors essentiellement un rôle de raccord électrique entre la couche de nanodiamant 4 et la couche mince 16 d'$Al_2O_3$ d'une part et la source de tension d'autre part, dans le but de permettre l'approvisionnement desdites couches en électrons destinés à être émis. La surface intérieure 14 du microcanal 12 n'a plus de rôle d'émission d'électrons secondaires puisque les couches 4 de nanodiamant et 16 d'$Al_2O_3$ remplissent cette fonction.

La couche 16 d'$Al_2O_3$ peut être déposée sur la surface intérieure 14 des microcanaux 12 préalablement à la formation de la couche de nanodiamant 4, par la technique connue de dépôt dite ALD pour Atomic Layer Déposition.

Ainsi, la couche 16 d'$Al_2O_3$ peut être déposée sur toute la longueur du canal.

On métallise ensuite l'entrée du canal en NiCr ou ITO à partir de l'orifice d'entrée 13A sur une longueur de deux à cinq fois le diamètre moyen du canal.

Enfin, on réalise le dépôt de la couche de nanodiamant 4 sur cette couche conductrice.

La couche de nanodiamant 4 peut ensuite être formée, selon la technique décrite précédemment en référence au mode de réalisation de l'invention.

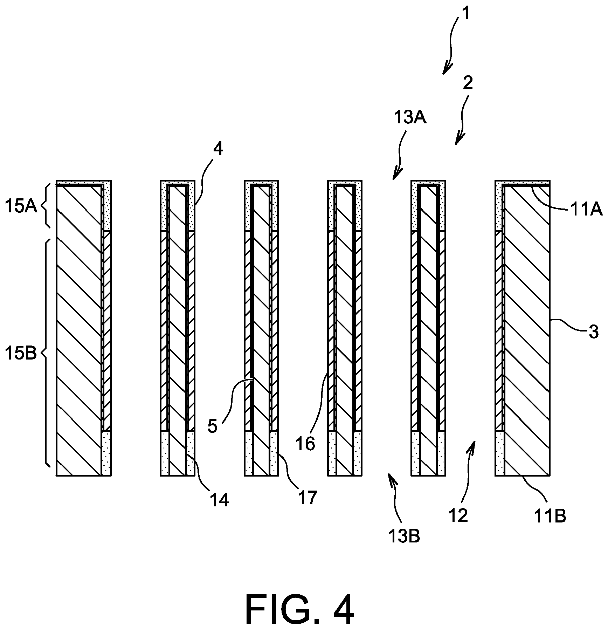

La figure 4 illustre une variante du dispositif multiplicateur d'électrons illustré en figure 3.

Les références numériques identiques à celles de la figure 3 précédemment décrite désignent des éléments identiques ou similaires.

Cette seconde variante diffère de la première variante décrite précédemment essentiellement en ce que le substrat 3 de la GMC 2 est réalisé en verre ($SiO_2$) et non plus uniquement en verre au plomb. Ainsi, la concentration en oxyde de plomb (PbO) est sensiblement nulle.

Ainsi, la surface intérieure 14 des microcanaux 12 ne présente plus la propriété électrique adéquate permettant d'assurer le raccord électrique entre la couche de nanodiamant 4 et la couche 16 d'$Al_2O_3$ avec la source de tension.

Une sous-couche 5 d'un matériau électriquement conducteur est alors prévue entre les couches de nanodiamant 4 et d'$Al_2O_3$ 16 d'une part et la surface intérieure 14 du microcanal 12 d'autre part. Cette sous-couche 5 assure ainsi le raccord électrique entre la couche de nanodiamant 4 et la couche 16 d'$Al_2O_3$ avec la source de tension, dans le but de fournir auxdites couches les électrons destinés à être émis.

Cette sous-couche 5 peut être réalisée en $Al_2O_3$ et ZnO, matériau habituellement appelé AZO, et être déposée par la technique connue de dépôt de couches atomiques (ALD en anglais, pour *Atomic Layer Deposition*). Son épaisseur peut être de l'ordre de 5nm à 30nm.

La couche de nanodiamant 4 peut ensuite être formée, selon la technique décrite précédemment en référence au mode de réalisation de l'invention.

Il est à noter que le substrat 3 est réalisé en verre et non plus en verre au plomb. L'étape de réduction du plomb n'est alors plus nécessaire, ce qui simplifie le procédé de réalisation de la GMC. De plus, la durée de vie de la GMC est augmentée dans la mesure où il n'y a plus d'atomes d'hydrogène, restés adsorbés à la surface intérieure des microcanaux lors de l'étape de réduction du plomb, et qui sont susceptibles d'être libérés et de venir dégrader la GMC ou la photocathode.

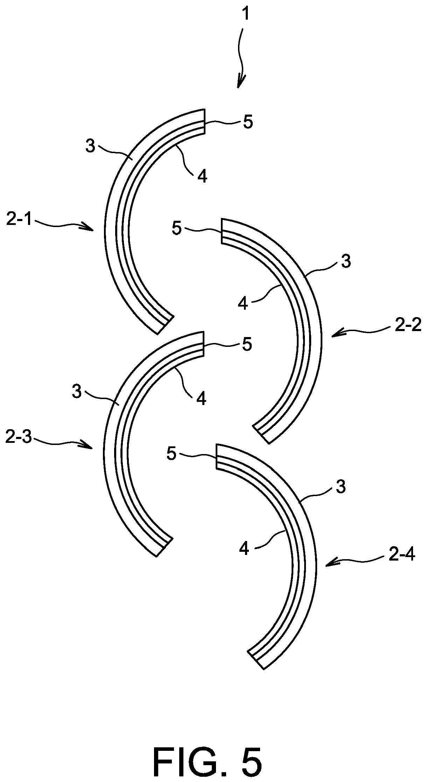

La figure 5 illustre partiellement et schématiquement un dispositif multiplicateur 1 comprenant un ensemble de dynodes 2-i. Chaque dynode 2-i forme ainsi une structure active 2 du dispositif multiplicateur.

Les références numériques identiques à celles de la figure 2 précédemment décrite désignent des éléments identiques ou similaires.

Ce type de multiplicateur d'électrons 1 est habituellement disposé dans un photomultiplicateur ou un détecteur de flux ionique.

Dans un photomultiplicateur, le multiplicateur d'électrons est disposé entre un dispositif d'entrée comportant une photocathode et une anode formant dispositif de sortie.

L'ensemble de dynodes 2-i représenté sur la figure 5 est de configuration *linear focusing*, cependant d'autres configurations peuvent être utilisées, par exemple *venetian blind, box, circular cage, mesh,* ou *foil.*

Chaque dynode 2-i comporte un substrat 3 dont une face est recouverte d'une couche à émission secondaire.

Au moins une dynode 2-1, de préférence la première suivant le sens de parcours des électrons, présente un substrat 3 dont une face est recouverte de la couche de nanodiamant 4 telle que présentée en référence au mode de réalisation de l'invention.

Les dynodes 2-i qui ne comportent pas ladite couche de nanodiamant 4 peuvent comporter une couche d'oxyde métallique, par exemple BeO, $Al_2O_3$, ou MgO, traitée au césium pour diminuer leur affinité électronique, ou une couche d'un matériau semi-conducteur adapté, par exemple $SbK_2Cs$ ou SbRbCs.

De préférence, toutes les dynodes 2-i comportent ladite couche de nanodiamant.

Dans le cas où le substrat est en un matériau diélectrique, par exemple en céramique, une sous-couche 5 en un matériau électriquement conducteur est prévue entre la surface du substrat 3 et la couche de nanodiamant 4. Cette sous-couche 5 est électriquement connectée à une source de tension (non représentée), permettant ainsi de polariser la dynode 2-i et de fournir à la couche de nanodiamant 4 les électrons destinés à être émis. Cette sous-couche 5 peut être déposée par des techniques classiques de dépôt sous vide, par exemple par ALD, par pulvérisation cathodique (*sputtering* en anglais), voire par évaporation.

Ainsi, le multiplicateur d'électrons présente un gain global particulièrement élevé dans la mesure où au moins une dynode, de préférence la première dynode, comporte ladite couche de nanodiamant. De plus, selon la relation (3), le temps de montée RT est préservé et donc les performances temporelles du multiplicateur.

Ainsi, sans qu'il soit nécessaire d'augmenter le nombre de dynodes, le multiplicateur d'électrons présente un gain global élevé et un temps de montée préservé par rapport aux dynodes selon l'art antérieur.

De plus, à gain égal, il est possible de diminuer le nombre de dynodes et de réduire sensiblement le temps de montée RT.

Il est à noter que la couche de diamant peut être obtenue et déposée de manière identique ou similaire au procédé décrit en référence au mode de réalisation de l'invention.

Bien entendu, diverses modifications peuvent être apportées par l'homme du métier à l'invention qui vient d'être décrite, uniquement à titre d'exemples non limitatifs.

Ainsi, le multiplicateur d'électrons peut être utilisé dans tous les types de photomultiplicateurs, par exemple le channeltron.

Ce type de photomultiplicateur comporte, entre la photocathode et l'anode de sortie, un dispositif multiplicateur d'électrons sous forme d'un unique canal dont la surface intérieure présente une propriété d'émission secondaire.

Le channeltron selon l'invention présente alors une surface intérieure de canal en partie recouverte de la couche de nanodiamant présentée précédemment.

La couche de nanodiamant peut être obtenue et déposée de manière identique ou similaire au procédé décrit en référence au mode de réalisation de l'invention.

Le channeltron présente alors les avantages similaires ou identiques à ceux décrits en référence au mode de réalisation de l'invention.

**EP 2 617 051 B1**

**Revendications**

**1.** Dispositif multiplicateur (1) d'électrons en réflexion, pour détecteur de rayonnement électromagnétique ou de flux ionique, comportant au moins une structure active (2) destinée à recevoir un flux d'électrons incidents et à émettre en réponse un flux d'électrons dits secondaires, ladite structure active (2) comportant un substrat (3), ladite structure active (2) étant une galette de microcanaux dans laquelle chacun desdits microcanaux (12) traverse ledit substrat (3) à partir d'un orifice d'entrée (13A) pour le flux d'électrons incidents jusqu'à un orifice de sortie (13B) pour le flux d'électrons secondaires, **caractérisé en ce que** la surface intérieure (14) de chacun desdits microcanaux est revêtue d'une monocouche mince de nanodiamant (4), ladite monocouche de nanodiamant ayant été obtenue en plongeant la galette de microcanaux à partir de la face d'entrée dans une solution colloïdale contenant des particules de diamant dont la taille moyenne est inférieur à 100 nm, ladite monocouche de nanodiamant (4) s'étendant sur la surface intérieure (14) de chacun desdits microcanaux (12) à partir de l'orifice d'entrée (13A) correspondant et s'arrêtant à une distance de l'ordre de une à dix fois le diamètre moyen des microcanaux à partir de l'orifice de sortie (13B), une couche de collection d'électrons (17) étant déposée sur la surface intérieure de chacun des microcanaux sur ladite distance de l'ordre de une à dix fois le diamètre moyen des microcanaux à partir de l'orifice de sortie (13B).

**2.** Dispositif multiplicateur (1) d'électrons selon l'une quelconque des revendications précédentes, **caractérisé en ce que** la taille moyenne des particules de diamant de ladite couche de nanodiamant (4) est comprise entre 1nm et 10nm.

**3.** Dispositif multiplicateur (1) d'électrons selon l'une quelconque des revendications précédentes, **caractérisé en ce que** ladite couche de nanodiamant (4) présente une épaisseur moyenne sensiblement inférieure à 50nm.

**4.** Dispositif multiplicateur (1) d'électrons selon l'une quelconque des revendications 1 à 3, **caractérisé en ce que** ladite couche de nanodiamant (4) est au contact du substrat (3), ledit substrat (3) étant électriquement conducteur et porté à un potentiel électrique prédéterminé.

**5.** Dispositif multiplicateur (1) d'électrons selon l'une quelconque des revendications 1 à 3, **caractérisé en ce que** ladite couche de nanodiamant (4) repose sur une sous-couche (5) d'un matériau électriquement conducteur, ladite sous-couche (5) étant au contact dudit substrat (3) et ledit substrat (3) étant électriquement isolant.

**6.** Dispositif multiplicateur (1) d'électrons selon la revendication 5, **caractérisé en ce que** ladite sous-couche (5) est réalisée en $Al_2O_3$ et ZnO, ou en MgO et ZnO.

**7.** Dispositif multiplicateur (1) d'électrons selon la revendication 4, **caractérisé en ce que** ledit substrat (3) de ladite galette de microcanaux (2) est réalisé à partir de verre au plomb.

**8.** Dispositif multiplicateur (1) d'électrons selon l'une des revendications 5 ou 6, **caractérisé en ce que** ledit substrat (3) de ladite galette de microcanaux (2) est réalisé à partir de verre et présente une concentration sensiblement nulle d'oxyde de plomb PbO.

**9.** Système de détection d'un rayonnement électromagnétique ou d'un flux ionique, **caractérisé en ce qu'**il comporte :

- un dispositif d'entrée, pour recevoir le rayonnement électronique ou le flux ionique et émettre en réponse un flux d'électrons dits primaires,
- un dispositif multiplicateur (1) d'électrons en réflexion selon l'une quelconque des revendications précédentes, pour recevoir ledit flux d'électrons primaires et émettre en réponse un flux d'électrons dits secondaires, et
- un dispositif de sortie, pour recevoir ledit flux d'électrons secondaires et émettre en réponse un signal de sortie.

**10.** Système de détection selon la revendication 9, **caractérisé en ce que** ladite couche de nanodiamant (4) est disposée de manière à recevoir ledit flux d'électrons primaires.

**11.** Système de détection selon l'une quelconque des revendications 9 ou 10, **caractérisé en ce que** le système de détection est un tube photomultiplicateur, un tube intensificateur d'image, ou un tube de détection d'un flux ionique.

**12.** Procédé de réalisation d'un dispositif multiplicateur (1) d'électrons en réflexion, pour détecteur de rayonnement électromagnétique ou de flux ionique, comportant au moins une structure active (2, 2i) destinée à recevoir un flux d'électrons incidents et à émettre en réponse un flux d'électrons dits secondaires, ladite structure active (2,2i) comportant ladite structure active (2) étant une galette de microcanaux dans laquelle chacun desdits microcanaux (12) traverse ledit substrat (3) à partir d'un orifice d'entrée (13A) pour le flux d'électrons incidents jusqu'à un orifice de sortie (13B) pour le flux d'électrons secondaires (3), **caractérisé en ce qu'**il comprend :

- une étape de formation d'une monocouche de nanodiamant (4) sur la surface intérieure de chacun des microcanaux, ladite étape comportant le plongement de la galette de microcanaux à partir de la face d'entrée dans une solution colloïdale contenant des particules de diamant dont la taille moyenne est inférieure à 100nm, dans un bain à ultrasons, pendant une durée prédéterminée de manière à ce que la monocouche de nanodiamant s'étende sur la surface intérieure de chacun des microcanaux et s'arrête à une distance de l'ordre de une à dix fois le diamètre moyen des microcanaux à partir de l'orifice de sortie (13B),
- une étape de dépôt d'une couche de collection d'électrons sur la surface intérieure de chacun des microcanaux sur ladite distance de une à dix fois le diamètre moyen des microcanaux à partir de l'orifice de sortie.

13. Procédé de réalisation d'un dispositif multiplicateur (1) d'électrons selon la revendication 12, **caractérisé en ce que** les particules de diamant présentent une taille moyenne inférieure ou égale à 10nm, ladite étape de bain à ultrasons étant précédée d'une étape de laminage des particules de diamant au moyen d'éléments de laminage à base de zirconium.

14. Procédé de réalisation d'un dispositif multiplicateur (1) d'électrons selon la revendication 13, **caractérisé en ce que** les particules de diamant sont préalablement obtenues par détonation.


**Patentansprüche**

1. Elektronenmultiplikatorvorrichtung (1) mit Reflexionsfunktion für einen Detektor für elektromagnetische Strahlung oder einen Ionenfluss, umfassend wenigstens eine aktive Struktur (2), die dazu ausgelegt ist, einen Fluss von einfallenden Elektronen zu empfangen und in Antwort einen Fluss von sogenannten Sekundärelektronen zu emittieren, wobei die aktive Struktur (2) ein Substrat (3) umfasst, wobei die aktive Struktur (2) eine Ebene von Mikrokanälen ist, wobei jeder der Mikrokanäle (12) das Substrat (3) durchsetzt ausgehend von einer Eingangsöffnung (13A) für den Fluss von einfallenden Elektronen bis zu einer Ausgangsöffnung (13B) für den Fluss von Sekundärelektronen, **dadurch gekennzeichnet, dass** die Innenoberfläche (14) von jedem der Mikrokanäle mit einer dünnen Monoschicht aus Nanodiamant (4) beschichtet ist, wobei die Monoschicht aus Nanodiamant erhalten worden ist durch Eintauchen der Ebene von Mikrokanälen ausgehend von der Eingangsfläche in eine kolloidale Lösung, die Diamantpartikel enthält, deren durchschnittliche Größe kleiner als 100 nm ist, wobei die Monoschicht aus Nanodiamant (4) sich über die Innenoberfläche (14) von jedem der Mikrokanäle (12) erstreckt ausgehend von der entsprechenden Eingangsöffnung (13A) und in einem Abstand in der Größenordnung von 1 bis 10 mal der mittlere Durchmesser der Mikrokanäle von der Ausgangsöffnung (13B) endet, wobei eine Elektronensammelschicht (17) auf der Innenoberfläche von jedem der Mikrokanäle aufgebracht ist in dem Abstand in der Größenordnung von 1 bis 10 mal der mittlere Durchmesser der Mikrokanäle von der Ausgangsöffnung (13B).

2. Elektronenmultiplikatorvorrichtung (1) nach einem der vorhergehenden Ansprüche, **dadurch gekennzeichnet, dass** die mittlere Größe der Diamantpartikel der Schicht aus Nanodiamant (4) zwischen 1 nm und 10 nm enthalten ist.

3. Elektronenmultiplikatorvorrichtung (1) nach einem der vorhergehenden Ansprüche, **dadurch gekennzeichnet, dass** die Schicht aus Nanodiamant (4) eine mittlere Dicke wesentlich kleiner als 50 nm aufweist.

4. Elektronenmultiplikatorvorrichtung (1) nach einem der Ansprüche 1 bis 3, **dadurch gekennzeichnet, dass** die Schicht aus Nanodiamant (4) in Kontakt mit dem Substrat (3) ist, wobei das Substrat (3) elektrisch leitend und auf ein vorbestimmtes elektrisches Potential gebracht ist.

5. Elektronenmultiplikatorvorrichtung (1) nach einem der Ansprüche 1 bis 3, **dadurch gekennzeichnet, dass** die Schicht aus Nanodiamant (4) auf einer Unterschicht (5) aus einem elektrisch leitenden Material ruht, wobei die Unterschicht (5) in Kontakt mit dem Substrat (3) ist, und das Substrat (3) elektrisch isolierend ist.

6. Elektronenmultiplikatorvorrichtung (1) nach Anspruch 5, **dadurch gekennzeichnet, dass** die Unterschicht (5) aus $Al_2O_3$ und ZnO oder aus MgO und ZnO hergestellt ist.

**7.** Elektronenmultiplikatorvorrichtung (1) nach Anspruch 4, **dadurch gekennzeichnet, dass** das Substrat (3) der Ebene von Mikrokanälen (2) ausgehend von Bleiglas hergestellt ist.

**8.** Elektronenmultiplikatorvorrichtung (1) nach einem der Ansprüche 5 oder 6, **dadurch gekennzeichnet, dass** das Substrat (3) der Ebene von Mikrokanälen (2) ausgehend von Glas hergestellt ist und eine Konzentration von Bleioxid PbO im Wesentlichen gleich Null aufweist.

**9.** System zur Detektion einer elektromagnetischen Strahlung oder eines Ionenflusses, **dadurch gekennzeichnet, dass** es Folgendes umfasst:

- eine Eingangsvorrichtung zum Empfangen der elektronischen Strahlung oder des Ionenflusses und zum Emittieren eines Flusses von sogenannten primären Elektronen in Antwort hierauf,
- eine Elektronenmultiplikatorvorrichtung (1) mit Reflexionsfunktion nach einem der vorhergehenden Ansprüche, um den Fluss von primären Elektronen zu empfangen und in Antwort einen Fluss von sogenannten sekundären Elektronen zu emittieren, und
- eine Ausgangsvorrichtung zum Empfangen des Flusses von sekundären Elektronen und zum Emittieren eines Ausgangssignals in Antwort hierauf.

**10.** System zur Detektion nach Anspruch 9, **dadurch gekennzeichnet, dass** die Schicht aus Nanodiamant (4) derart angeordnet ist, dass sie den Fluss von primären Elektronen empfängt.

**11.** System zur Detektion nach einem der Ansprüche 9 oder 10, **dadurch gekennzeichnet, dass** das System zur Detektion eine Fotomultiplikatorröhre, eine Bildverstärkerröhre oder eine Röhre zur Detektion eines Ionenflusses ist.

**12.** Verfahren zur Herstellung einer Elektronenmultiplikatorvorrichtung (1) mit Reflexionswirkung für einen Detektor für elektromagnetische Strahlung oder einen Ionenfluss, umfassend wenigstens eine aktive Struktur (2, 2i), die dazu ausgelegt ist, einen Fluss von einfallenden Elektronen zu empfangen und in Antwort hierauf einen Fluss von sogenannten Sekundärelektronen zu emittieren, wobei die aktive Struktur (2, 2i), die die aktive Struktur (2) umfasst, eine Ebene von Mikrokanälen ist, wobei jeder der Mikrokanäle (12) das Substrat (3) durchsetzt ausgehend von einer Eingangsöffnung (13A) für den Fluss von einfallenden Elektronen bis zu einer Ausgangsöffnung (13B) für den Fluss von Sekundärelektronen (3), **dadurch gekennzeichnet, dass** es Folgendes umfasst:

- einen Schritt des Bildens einer Monoschicht aus Nanodiamant (4) auf der Innenoberfläche von jedem der Mikrokanäle, wobei der Schritt das Eintauchen der Ebene von Mikrokanälen ausgehend von der Eingangsfläche in eine kolloidale Lösung umfasst, die Diamantpartikel enthält, deren mittlere Größe kleiner als 100 nm ist, und zwar in ein Ultraschallbad während einer vorbestimmten Dauer derart, dass sich die Monoschicht aus Nanodiamant über die Innenoberfläche von jedem der Mikrokanäle erstreckt und in einem Abstand in der Größenordnung von 1 bis 10 mal den mittleren Durchmesser der Mikrokanäle von der Ausgangsöffnung (13B) endet,
- einen Schritt des Aufbringens einer Elektronensammelschicht auf die Innenoberfläche von jedem der Mikrokanäle bei dem Abstand von 1 bis 10 mal den mittleren Durchmesser der Mikrokanäle von der Ausgangsöffnung.

**13.** Verfahren zur Herstellung einer Elektronenmultiplikatorvorrichtung (1) nach Anspruch 12, **dadurch gekennzeichnet, dass** die Diamantpartikel eine mittlere Größe kleiner oder gleich 10 nm aufweisen, wobei dem Schritt im Ultraschallbad ein Schritt des Laminierens der Diamantpartikel mit Hilfe von Laminierelementen auf Basis von Zirkonium vorhergeht.

**14.** Verfahren zur Herstellung einer Elektronenmultiplikatorvorrichtung (1) nach Anspruch 13, **dadurch gekennzeichnet, dass** die Diamantpartikel zuvor durch Detonation erhalten worden sind.

**Claims**

**1.** A reflection-mode electron multiplier device (1) to detect electromagnetic radiation or ion flows, including at least one active structure (2) intended to receive a flow of incident electrons and to emit in response of flow of electrons called secondary electrons, where the said active structure (2) includes a substrate (3), said active structure being a microchannel wafer (2), in which each of the said microchannels (12) traverses the said substrate (3) from an input aperture (13A) for the flow of incident electrons to an output aperture (13B) for the flow of secondary electrons, **characterised in that** the inner surface (14) of each of the said microchannels (12) is coated with a thin nanodiamond monolayer (4), said nanodiamond layer being obtained by dipping the microchannel wafer, from the input face thereof, in a colloidal solution containing diamond particles having an average size below 100 nm, said nanodiamond monolayer (4) extending on the inner surface of each of the said microchannels (12), from the corresponding input aperture (13A) up to a distance, relative to said corresponding output aperture (13B), of between one and ten times the average diameter of the microchannels (12), an electron collection layer (17) being deposited on the inner surface of each of the microchannels over said distance of between one and ten times the average diameter of the microchannels (12) relative to said output aperture (13B).

2. An electron multiplier device (1) according to any one of the previous claims, **characterised in that** the average size of the diamond particles of the said nanodiamond layer (4) is between 1 nm and 10 nm.

3. An electron multiplier device (1) according to any one of the previous claims, **characterised in that** the said nanodiamond layer (4) has an average thickness of substantially less than 50 nm.

4. An electron multiplier device (1) according to any one of claims 1 to 3, **characterised in that** the said nanodiamond layer (4) is in contact with the substrate (3), where the said substrate (3) is electrically conductive, and is at a predetermined electric potential.

5. An electron multiplier device (1) according to any one of claims 1 to 3, **characterised in that** the said nanodiamond layer (4) is lying on a sub-layer (5) of an electrically conductive material, where the said sub-layer (5) is in contact with the said substrate (3), and where the said substrate (3) is electrically insulating.

6. An electron multiplier device (1) according to claim 8, **characterised in that** the said sub-layer (5) is made of $Al_2O_3$ and ZnO, or MgO and ZnO.

7. An electron multiplier device (1) according to claim 4, **characterised in that** the said substrate (3) of the said microchannel wafer (2) is made from lead glass.

8. An electron multiplier device (1) according to either of claims 5 or 6, **characterised in that** the said substrate (3) of the said microchannel wafer (2) is made from lead glass and has a substantially zero lead oxide PbO concentration.

9. A system for detecting electromagnetic radiation or an ion flow, **characterised in that** it includes:

   - an input device, to receive the electronic radiation or ion flow, and to emit in response a flow of electrons called primary electrons,
   - a reflection-mode electron multiplier device (1) according to any of the previous claims, to receive the said flow of primary electrons and to emit in response a flow of electrons called secondary electrons, and
   - an output device, to receive the said flow of secondary electrons, and to emit an output signal in response.

10. A detection system according to claim 9, **characterised in that** the said nanodiamond layer (4) is positioned so as to receive the said flow of primary electrons.

11. A detection system according to either of claims 9 or 10, **characterised in that** the detection system is a photomultiplier tube, an image intensifier tube, or a tube for detecting an ion flow.

12. A method for producing a reflection-mode electron multiplier device (1), to detect electromagnetic radiation or an ion flow, including at least one active structure (2, 2i) intended to receive a flow of incident electrons and to emit in response a flow of electrons called secondary electrons, said active structure (2, 2i) including a microchannel wafer (2), in which each of the said microchannels (12) traverses the said substrate (3) from an input aperture (13A) for the flow of incident electrons to an output aperture (13B) for the flow of secondary electrons, **characterised in that** it includes:

   - a step of formation of a nanodiamond monolayer (4) on the inner surface of each of the microchannels, said step including dipping the microchannel wafer, from the input face thereof, in a colloidal solution containing diamond particles having an average size below 100 nm, in an ultrasonic bath, for a predetermined period, such that the nanodiamond monolayer extends on the inner surface of each of the said microchannels (12) up to a distance, relative to said corresponding output aperture (13B), of between one and ten times the average diameter of the microchannels (12),

- a step of depositing an electron collection layer on the inner surface of each of the microchannels over said distance of between one and ten times the average diameter of the microchannels (12) relative to said output aperture (13B).

13. A method for producing an electron multiplier device (1) according to claim 12, **characterised in that** the diamond particles have an average size of less than or equal to 10 nm, where the said step of an ultrasonic bath is preceded by a step of lamination of the diamond particles by means of zirconium-based lamination elements.

14. A method of producing an electron multiplier device (1) according to claim 13, **characterised in that** the diamond particles are previously obtained by detonation.

FIG. 1A

FIG. 1B

# FIG. 2

# FIG. 3

FIG. 4

FIG. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090212680 A

**Littérature non-brevet citée dans la description**

- **WERNICK ; AARSVOLD.** Emission tomography : the fundamentals of PET and SPECT. Academic Press Inc, 2004
- **WILLIAMS et al.** Enhanced diamond nucleation on monodispersed nanocrystalline diamond. *Chem. Phys. Lett.,* 2007, vol. 445, 255-258
- **GROWTH.** electronic properties and applications of nanodiamond. *Diam. Relat. Mater.,* 2008, vol. 17, 1080-1088